# EUROPÄISCHE PATENTSCHRIFT

(11) **EP 1 743 388 B1**
(45) Veröffentlichungstag und Bekanntmachung des Hinweises auf die Patenterteilung: **14.03.2012**
(21) Anmeldenummer: 05741074.8
(22) Anmeldetag: 03.05.2005
(51) Int. Cl.: H01L 51/00

(54) **ELEKTRONISCHE VORRICHTUNGEN ENTHALTEND ORGANISCHE HALBLEITER**
ELECTRONIC DEVICES COMPRISING ORGANIC SEMICONDUCTORS
DISPOSITIFS ELECTRONIQUES CONTENANT DES SEMI-CONDUCTEURS ORGANIQUES

(30) Priorität: 03.05.2004 DE 102004021567
(43) Veröffentlichungstag der Anmeldung: 17.01.2007
(73) Patentinhaber: Merck Patent GmbH, 64293 Darmstadt (DE)
(72) Erfinder: BECKER, Heinrich, 65719 Hoffheim (DE); STREY, Reinhard, 41542 Dormagen (DE); MEERHOLZ, Klaus, 51503 Rösrath (DE); MÜLLER, David, Christoph, 80805 München (DE)
(86) Internationale Anmeldenummer: PCT/EP2005/004793
(87) Internationale Veröffentlichungsnummer: WO 2005/109539

(56) Entgegenhaltungen:
- WO-A-00/04593
- WO-A-03/047316
- FR-A- 2 559 492
- US-A- 6 060 530
- PATENT ABSTRACTS OF JAPAN Bd. 2002, Nr. 08, 5. August 2002 (2002-08-05) -& JP 2002 117984 A (AUTO NETWORK GIJUTSU KENKYUSHO:KK; SUMITOMO WIRING SYST LTD; SUMITOMO), 19. April 2002 (2002-04-19)
- BAYERL M S: "Crosslikable hole-transport materials for preparation of multilayer organic light emitting devices by spin-coating" MACROMOLECULAR: RAPID COMMUNICATIONS, WILEY VCH VERLAG, WEINHEIM, DE, Bd. 20, Nr. 4, 1999, Seiten 224-228, XP002193426 ISSN: 1022-1336
- PATENT ABSTRACTS OF JAPAN Bd. 2000, Nr. 21, 3. August 2001 (2001-08-03) -& JP 2001 106782 A (CHEMIPROKASEI KAISHA LTD), 17. April 2001 (2001-04-17)

## Beschreibung

Elektronische Vorrichtungen, welche organische, metallorganische oder polymere Halbleiter enthalten, werden immer häufiger in kommerziellen Produkten verwendet oder stehen kurz vor der Markteinführung. Als Beispiele für bereits kommerzielle Produkte seien hier Ladungstransportmaterialien auf organischer Basis (in der Regel Lochtransporter auf Triarylaminbasis) in Kopiergeräten und Laserdruckern, sowie organische oder polymere Leuchtdioden (OLEDs, PLEDs) in Anzeige- oder Display-Vorrichtungen genannt. Organische Solarzellen (O-SCs), organische optische Verstärker, Sensoren oder organische Laserdioden (O-Laser) sind in einem Forschungsstadium weit fortgeschritten und könnten in der Zukunft große Bedeutung erlangen.

Diese Vorrichtungen weisen folgenden allgemeinen Schichtaufbau auf, der für die einzelnen Anwendungen entsprechend angepasst wird:
(1) Substrat, im Allgemeinen aus Glas oder Kunststoff;
(2) Kontaktierung (Elektrode): leitfähige Substanz, häufig metallisch oder anorganisch;
(3) Eventuell Ladungsinjektionsschicht, häufig aus einem leitfähigen, dotierten Polymer;
(4) Organischer Halbleiter, gegebenenfalls mehrere Schichten;
(5) Eventuell Isolierschicht;
(6) Zweite Kontaktierung (zweite Elektrode): wie (2), Materialien wie oben genannt;
(7) Verschaltung;
(8) Verkapselung.

Dabei muss für die oben genannten Anwendungen mindestens eine der Elektroden transparent oder zumindest teilweise transparent sein, um Licht einstrahlen zu können, wie im Falle organischer Solarzellen oder Detektoren, oder auskoppeln zu können, wie im Falle organischer bzw. polymerer Leuchtdioden, organischer Laserdioden oder organischer optischer Verstärker.

Trotz aller in den letzten Jahren erzielten Fortschritte gibt es immer noch Probleme, die einer deutlichen Verbesserung bedürfen. Der Aufbau einer herkömmlichen OLED aus mehreren Schichten mit unterschiedlichen optischen Eigenschaften (unterschiedlichen Brechungsindizes n) führt nach der Faustformel ηₒᵤₜ ≈ 1/(2n²) (wobei ηₒᵤₜ die Auskopplungseffizienz beschreibt, also die Wahrscheinlichkeit, mit der ein in der Emissionszone erzeugtes Photon aus der Diode ausgekoppelt wird, und n der höchste Brechungsindex der Vorrichtung ist) zu einem Verlust von über 70 % des erzeugten Lichts durch interne Reflexion/Wellenleitung und Absorption in den Schichten. In einer konventionellen OLED werden also lediglich ca. 20 - 30 % des erzeugten Lichts genutzt, während ca. 50 % durch Wellenleitung in den ITO (Indium-Zinn-Oxid)/Polymer-Schichten und ca. 30 % durch Wellenleitung im Substrat und Absorption in den Wellenleitern verloren gehen (C. F. Madigan et al., Appl. Phys. Lett. 2000, 76, 1650). Während in jüngster Zeit die interne elektrooptische Effizienz bis nahe an die theoretische Grenze gesteigert werden konnte, muss die Lichtauskopplung noch deutlich verbessert werden. Dies wird zur Erhöhung der Lebensdauer und einer Reduzierung der Leistungsaufnahme beitragen, womit das Anwendungspotenzial von OLEDs signifikant erhöht wird. Die bisher beschriebenen Methoden, die Lichtauskopplung von OLEDs zu erhöhen, sind mit Strukturen oder Schichten gelungen, die nicht aktiv mit der OLED-Funktion verknüpft sind. Ein wesentlicher Nachteil ist die fehlende Kompatibilität zur OLED-Herstellung bzw. die Verwendung sehr aufwändiger Verfahren und Prozesse, die das Ergebnis nicht rechtfertigen. Zum Teil führen die Methoden zu wesentlichen Einschränkungen der Anwendungsfelder von OLEDs. Einige Methoden werden im Folgenden kurz beschrieben.

Durch den Einsatz von Mikrolinsen konnte die Auskopplungseffizienz um einen Faktor von ca. 1.5 erhöht werden (C. F. Madigan et al., Appl. Phys. Lett. 2000, 76, 1650). Allerdings wird das gewonnene Licht nicht in Richtung der Flächennormalen emittiert und die mechanische Oberflächenbeschaffenheit wird nachteilig verändert. Die erforderliche exakte Ausrichtung der Mikrolinsen auf das Pixelelement eines Displays ist aufwändig. Außer für Beleuchtungsanwendungen ist das unscharfe Erscheinungsbild von Nachteil. Außerdem kommt es zu Farbverschiebungen bei seitlicher Betrachtung.

Durch Strukturierung des Glassubstrats oder einer geeigneten Schicht wie SiNₓ können ein-, zwei und dreidimensionale photonische Kristalle mit regelmäßiger oder unregelmäßiger Periode erzeugt werden (Y.-J. Lee et al., Appl Phys. Lett. 2003, 82, 3779). Diese extrahieren Licht aus der ITO/Polymer-Grenzfläche, welches in der Schicht mit dem höheren Brechungsindex (ITO) durch kombinierte Wellenleitung und Absorption verloren geht. Die Strukturbreiten und Tiefen liegen im Bereich einiger zehn bis einiger hundert Nanometer. Die erzielte Verbesserung in der Lichtauskopplung liegt im Bereich von 50 %. Die Emission wird jedoch winkelabhängig, und die Verfahren sind technisch sehr aufwändig.

Die Verwendung von Bragg-Beugungsgittern kann zur Erhöhung der Lichtausbeute um den Faktor 2 führen (J. M. Lupton et al., Appl. Phys. Lett. 2000, 77, 3340). Dabei wird eine Schicht zwischen Substrat und ITO-Elektrode eingebracht und strukturiert. Die Periode des Gitters liegt im Bereich der halben Emissionswellenlänge mit Modulationstiefen in der Größenordnung der OLED-Dicke (50 - 100 nm). Da dadurch der planare Schichtaufbau verloren geht, muss zur Vermeidung von elektrischen Defekten die Schichtdicke der OLED verdoppelt werden, wodurch sich die interne Effizienz des Bauteils drastisch verringert.

Der Aufbau einer OLED zwischen zwei reflektierenden Elektroden ermöglicht die Ausnutzung von Mikro-Resonatoreffekten. Dabei werden die Moden der Emission im Vergleich zum Vakuum derart eingeschränkt, dass bei Erfüllung der Resonanzbedingungen nur noch wenige Moden emittiert werden, was eine sehr schmale Lichtemission von wenigen nm erlaubt (N. Takada et al., Appl. Phys. Lett. 1993, 63, 2032). Da die Lumineszenzspektren von Polymeren sehr breit sind, wird die Intensität der nun wegen der räumlichen Einschränkung nicht mehr erlaubten Übergänge in diese Moden eingekoppelt. Die Auskoppeleffizienz kann um einen Faktor 10 erhöht werden, jedoch wird die Emission stark gerichtet. Ein weiterer Nachteil ist wieder die erhöhte Schichtdicke der aktiven Schichten, um die Resonanzbedingung zu erfüllen; diese sollte im Bereich der halben Wellenlänge des Emissionslichtes liegen. Diese dicken Emissionsschichten sind im Allgemeinen außerhalb des Optimums, was zu einer Verringerung der Effizienz führt. Außerdem ist die Herstellung der Schichten mit der erforderlichen Präzision sehr aufwändig.

Das Einfügen einer Aerogel-Schicht mit einem niedrigen Brechungsindex zwischen die Anode und das Glassubstrat verringert die interne Reflexion im Glassubstrat und erhöht die Lichtausbeute um einen Faktor 2 (EP 1100129; T. Tsutsui et al., Adv. Mater. 2001, 13, 1149). Von Nachteil ist die schwierige Präparation des Aerogels und seine mechanische Labilität. Außerdem kann die ITO-Elektrode erst nach Preparation des Aerogels aufgetragen werden, was dadurch nicht nach den geläufigen Methoden geschehen kann. Weiterhin sind die aktiven Schichten (ITO und organischer Halbleiter) sehr dünn (insgesamt im Bereich von 200 nm). Dadurch wird in dieser Schicht weniger Wellenleitung beobachtet. Für die praktische Anwendung können diese Schichten jedoch nicht so dünn gewählt werden. So muss in der Praxis die ITO-Elektrode in der Größenordnung von 170 nm dick sein, um eine ausreichende elektrische Leitfähigkeit zu gewährleisten. Außerdem ist der organische Halbleiter im Allgemeinen aus mehreren Schichten aufgebaut, die insgesamt auch eine Dicke von mehr als 100 nm aufweisen. Damit wird die ITO- und Halbleiter-Schicht dicker, und auch hier erleidet man Verluste durch Totalreflexion und Wellenleitung in der ITO/Halbleiter-Schicht, die durch den gewählten Aufbau der Vorrichtung nicht ausgeglichen werden können.

In WO 03/061026 werden in mindestens einer der organischen Schichten organische Inhomogenitäten mit unterschiedlichem Brechungsindex eingebracht, um somit die Wellenleiteffekte zu stören. Praktisch wird die Entmischung verschiedener Polymerblends angewandt, was zur Streuung des Lichts und damit zur Steigerung der Auskopplungseffizienz führt. Diese Methode hat jedoch den Nachteil, dass Phasenseparation in den aktiven Schichten einer OLED zu deutlichen Verschlechterungen der elektronischen Eigenschaften der OLED führen kann, so dass für die höhere Auskopplungseffizienz eine eingeschränkte Funktion der OLED in Kauf genommen werden muss.

In der WO 03/0047316 A1 werden organische Licht-emittierende Vorrichtungen offenbart, enthaltend ein Substrat, eine erste Elektrode, mindestens eine organische Licht-emittierende Schicht und eine zweite Elektrode. Die organischen Schichten weisen dabei Brechungsindices auf, die im Bereich von 1,6 bis 1,8 liegen.

In der WO 00/04593 A1 werden optische Vorrichtungen offenbart, welche Schichten aufweisen, die organische Materialein enthalten, die eine im wesentlichen einheitliche Dispersion von lichtdurchlässigen Nanopartikeln enthalten. Die Schichten weisen dabei Brechungsindices auf, die im Bereich von 1,77 bis 2,60 liegen.

Wie man also sieht, sind im Bereich der Auskopplung noch deutliche Verbesserungen nötig. Ein wichtiges Ziel ist also die Steigerung der Lichtausbeute und damit verbunden die Verringerung der Leistungsaufnahme. Mit einer geringeren Leistungsaufnahme kann auch die Lebensdauer der Vorrichtung erhöht werden. Besonders wichtig ist dabei, dass die Erhöhung der Auskopplung technisch einfach realisierbar und mit dem allgemein gebräuchlichen Aufbau der elektronischen Vorrichtung kompatibel ist.

Überraschend wurde nun gefunden, dass die Ein- und Auskopplung von Licht aus einer organischen elektronischen Vorrichtung deutlich verbessert wird, wenn zwischen die transparente Elektrode und den organischen Halbleiter eine leitende oder halbleitende organische Schicht eingebracht wird, die einen niedrigen Brechungsindex aufweist.

Gegenstand der Erfindung sind daher organische elektronische Vorrichtungen, enthaltend Kathode und Anode, von denen mindestens eine transparent ist, und mindestens eine Schicht, enthaltend mindestens einen organischen Halbleiter, dadurch gekennzeichnet, dass zwischen die transparente Elektrode und die Schicht, die den organischen Halbleiter enthält, mindestens eine poröse, organische Pufferschicht eingebracht ist, welche einen Brechungsindex < 1.6 aufweist und deren Porengröße im Nanometerbereich liegt.

Diese organische Schicht mit niedrigem Brechungsindex wird im Folgenden kurz "Pufferschicht" genannt.

Unter einem niedrigen Brechungsindex im Sinne dieser Erfindung wird ein Brechungsindex n < 1.6 verstanden, bevorzugt n < 1.5, besonders bevorzugt < 1.4. Der Brechungsindex organischer Materialien liegt im Allgemeinen zwischen 1.4 und 1.7, die der relevanten organischen Lochtransport-Materialien zwischen 1.6 und 1.7. Besonders bevorzugt liegt der Brechungsindex n der Pufferschicht zwischen 1.2 und 1.4. Auch ein noch geringerer Brechungsindex ist bevorzugt, technisch aber nur sehr schwer realisierbar. Die Messung des Brechungsindex der dünnen Schichten kann durch unterschiedliche Methoden erfolgen, beispielsweise durch Ellipsometrie (R. M. A. Azzam, N. M. Bashara, "Ellipsometry and Polarized Light", North Holland Physics, 1987), durch einen Prismenkoppler oder durch Oberflächenplasmonenresonanzspektroskopie.

Unter einer transparenten Kathode bzw. Anode im Sinne dieser Erfindung wird eine Kathode bzw. Anode verstanden, die durchlässig im Bereich des eingestrahlten bzw. ausgekoppelten Lichtes ist, bevorzugt im Bereich von 400 bis 800 nm, wobei die Transmission bevorzugt mindestens 30 % beträgt, besonders bevorzugt mindestens 50 %, ganz besonders bevorzugt mindestens 80 %. In einigen Deviceaufbauten (Light Emitting Electrochemical Cell) werden auch unipolare Elektroden verwendet.

Bevorzugt handelt es sich bei der organischen elektronischen Vorrichtung um eine organische oder polymere Leuchtdiode (OLED, PLED, z. B. EP 0676461, WO 98/27136). In diesem Fall ist mindestens einer der organischen Halbleiter eine emittierende (fluoreszierende oder phosphoreszierende) Verbindung.

Weiterhin bevorzugt handelt es sich bei der organischen elektronischen Vorrichtung um eine organische Solarzelle (O-SC, z. B. WO 98/48433, WO 94/05045). Weiterhin bevorzugt handelt es sich bei der organischen elektronischen Vorrichtung um eine organische Laserdiode (O-Laser, z. B. WO 98/03566).

Weiterhin bevorzugt handelt es sich bei der organischen elektronischen Vorrichtung um ein organisches Field-Quenching-Device (O-FQD, z. B. US 04/017148). Weiterhin bevorzugt handelt es sich bei der organischen elektronischen Vorrichtung um einen organischen optischen Verstärker.

Weiterhin bevorzugt handelt es sich bei der organischen elektronischen Vorrichtung um einen organischen optischen Detektor.

Organisch im Sinne dieser Erfindung bedeutet, dass mindestens eine leitende oder halbleitende organische Pufferschicht und mindestens eine Schicht, enthaltend mindestens einen organischen Halbleiter, vorhanden sind; es können auch weitere organische Schichten (beispielsweise Elektroden) vorhanden sein. Es können durchaus auch Schichten vorhanden sein, die nicht auf organischen Materialien basieren, wie beispielsweise anorganische Zwischenschichten oder Elektroden.

Die elektronische Vorrichtung ist im einfachsten Fall aufgebaut aus Substrat, Elektrode, erfindungsgemäßer leitender oder halbleitender Pufferschicht mit niedrigem Brechungsindex, organischer Halbleiterschicht und Gegenelektrode. Außerdem kann es sinnvoll sein, in die Vorrichtung noch weitere Schichten einzubringen, beispielsweise eine Ladungsinjektionsschicht aus einem leitfähigen dotierten Polymer und/oder weitere organische Halbleiterschichten.

Die Elektroden werden in der Regel so gewählt, dass ihr Potenzial möglichst gut mit dem Potenzial der angrenzenden organischen Schicht übereinstimmt, um eine möglichst effiziente Elektronen- bzw. Lochinjektion zu gewährleisten.

Als Kathode sind Metalle mit geringer Austrittsarbeit, Metalllegierungen oder mehrlagige Strukturen mit verschiedenen Metallen bevorzugt, wie beispielsweise Erdalkalimetalle, Alkalimetalle, Hauptgruppenmetalle oder Lanthanide (z. B. Ca, Ba, Mg, Al, In, Mg, Yb, Sm, etc.). Bei mehrlagigen Strukturen können auch zusätzlich weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag, verwendet werden. Die Kathoden oder Kathodenkombinationen sind üblicherweise zwischen 10 und 10000 nm, bevorzugt zwischen 20 und 1000 nm dick.

Es kann auch bevorzugt sein, zwischen eine metallische Kathode und den organischen Halbleiter (bzw. anderen gegebenenfalls anwesenden funktionellen Schichten) eine dünne Zwischenschicht eines Materials mit einer hohen Dielektrizitätskonstanten einzubringen. Hierfür kommen beispielsweise Alkalimetall- oder Erdalkalimetallfluoride, aber auch die entsprechenden -oxide in Frage (z. B. LiF, Li₂O, BaF₂, MgO, NaF, etc.). Die Schichtdicke dieser dielektrischen Schicht beträgt bevorzugt zwischen 0.1 und 10 nm.

Als Anode sind Materialien mit hoher Austrittsarbeit bevorzugt. Bevorzugt weist die Anode ein Potenzial größer 4.5 eV *vs*. Vakuum auf. Geeignete Anodenmaterialien sind leitfähige gemischte Metalloxide, insbesondere Indium-Zinn-Oxid (ITO) oder Indium-Zink-Oxid (IZO). Weiterhin sind hierfür Metalle mit hohem Redoxpotenzial geeignet, wie beispielsweise Ag, Pt oder Au. Es können auch Metall/Metalloxid-Elektroden (z. B. Al/Ni/NiOₓ, Al/Pt/PtOₓ) bevorzugt sein. Die Anode kann auch aus einem leitfähigen, dotierten organischen Material (z. B. ein leitfähiges, dotiertes Polymer) bestehen.

Für die Einstrahlung und/oder Auskopplung von Licht muss mindestens eine der Elektroden transparent sein. Ein bevorzugter Aufbau verwendet eine transparente Anode, wobei auch Aufbauten mit transparenten Kathoden bekannt sind. Besonders bevorzugte transparente Anoden sind Indium-Zinn-Oxid (ITO) oder Indium-Zink-Oxid (IZO). Ganz besonders bevorzugt ist eine Indium-Zinn-Oxid-Anode; diese hat überlicherweise einen Brechungsindex n_{ITO} im Bereich von 1.6 - 2.0. Bevorzugt sind weiterhin leitfähige, dotierte organische Materialien, insbesondere leitfähige dotierte Polymere.

Als organische Halbleiter kommen prinzipiell niedermolekulare, oligomere, dendritische oder polymere halbleitende Materialien in Frage. Dabei können in einer Schicht auch mehrere organische Halbleiter gemischt vorliegen, oder ein oder mehrere organische Halbleiter können mit einer oder mehreren Verbindungen, die keine organischen Halbleiter sind, zusammen verwendet werden. Es können auch mehrere Schichten organischer Halbleiter vorliegen. Unter einem organischen Material im Sinne dieser Erfindung sollen nicht nur rein organische Verbindungen, sondern auch metallorganische Verbindungen und Metallkoordinationsverbindungen mit organischen Liganden verstanden werden. Dabei können die oligomeren, dendritischen oder polymeren Materialien konjugiert, nicht-konjugiert oder auch teilkonjugiert sein. Typische Vertreter konjugierter Polymere, wie sie beispielsweise in PLEDs oder O-SCs verwendet werden können, sind Poly-para-phenylenvinylen (PPV), Systeme, die im weitesten Sinne auf Poly-p-phenylen (PPP) basieren, Polyfluorene, Poly(spirobifluorene), Poly(indenofluorene), Polyphenanthrene, Polythiophene, etc. und Derivate dieser Strukturen.

Die Schichtdicke des organischen Halbleiters bzw. die Gesamtschichtdicke der organischen Halbleiter, falls mehrere Schichten verwendet werden, beträgt je nach Anwendung bevorzugt 10 - 300 nm, besonders bevorzugt 20 - 150 nm, ganz besonders bevorzugt 30 - 100 nm, insbesondere 40 - 80 nm.

Es kann auch bevorzugt sein, eine leitfähige organische Verbindung als Ladungsinjektionsschicht zu verwenden, insbesondere eine Lochinjektionsschicht auf der Anode. Hier können beispielsweise verschiedene organische, dotierte leitfähige Polymere verwendet werden, aber auch Phthalocyanine, wie beispielsweise Kupferphthalocyanin. Bevorzugt sind Polymere, die je nach Anwendung eine Leitfähigkeit von > 10⁻⁸ S/cm aufweisen. Als Lochinjektionsschicht beträgt das Potenzial der Schicht bevorzugt 4 bis 6 eV vs. Vakuum. Die Schichtdicke beträgt bevorzugt zwischen 10 - 500 nm, besonders bevorzugt zwischen 20 - 250 nm. Besonders bevorzugt werden dotierte Derivate von Polythiophen, ganz besonders bevorzugt Poly(ethylendioxythiophen) (PEDOT), und Polyanilin (PANI) verwendet. Die Dotierung erfolgt in der Regel durch Brönsted- und/oder Lewis-Säuren oder Oxidationsmittel. Das leitfähige Polymer wird in der Regel aus einer wässrigen Lösung oder Dispersion aufgetragen und ist unlöslich in organischen Lösungsmitteln. Dadurch kann die Folgeschicht aus organischen Lösemitteln problemlos aufgebracht werden.

In einer bevorzugten Ausführungsform der Erfindung wird die organische Pufferschicht mit niedrigem Brechungsindex dadurch erzeugt, dass Verbindungen mit niedrigem Brechungsindex verwendet werden bzw. die verwendeten Verbindungen chemisch so modifiziert werden, dass Verbindungen bzw. Schichten mit niedrigem Brechungsindex entstehen.

In einer besonders bevorzugten Ausführungsform der Erfindung wird die organische Pufferschicht mit niedrigem Brechungsindex dadurch erzeugt, dass zusätzlich zu den elektronisch aktiven Verbindungen oder als Substituenten daran lange Alkylketten verwendet werden. Diese weisen generell einen geringeren Brechungsindex auf als die Verbindungen, die üblicherweise als elektronisch aktive Verbindungen, beispielsweise Lochtransportverbindungen, verwendet werden und können so den Gesamtbrechungsindex der Schicht senken. Dies ist beispielsweise auch hinten in Beispiel 1 belegt.

In einer weiteren besonders bevorzugten Ausführungsform der Erfindung wird die organische Pufferschicht mit niedrigem Brechungsindex dadurch erzeugt, dass die elektronisch aktiven Verbindungen mit Fluor substituiert werden. Fluorierte Verbindungen weisen generell einen geringeren Brechungsindex auf und können so den Gesamtbrechungsindex der Schicht senken.

In einer ganz besonders bevorzugten Ausführungsform der Erfindung werden Fluorsubstituierte elektronisch aktive Verbindungen in Kombination mit langen Alkylketten, die gegebenenfalls auch fluoriert sein können, verwendet. Dadurch kann der Brechungsindex der Schicht noch weiter gesenkt werden.

In nochmals einer bevorzugten Ausführungsform der Erfindung handelt es sich bei der erfindungsgemäßen organischen Pufferschicht mit niedrigem Brechungsindex um eine poröse Schicht bzw. eine Schaumschicht, deren Porengröße im Nanometerbereich liegt. Dadurch wird ein Material mit niedrigem Brechungsindex erzeugt.

Unter einem Schaum im Sinne dieser Erfindung wird ein Gebilde aus gasgefüllten, kugel- oder polyederförmigen Zellen verstanden, welche durch feste Zellstege begrenzt werden. Die Zellstege bilden ein zusammenhängendes Gerüst. Schäume können durch Verfestigung der aufbauenden Substanz fixiert werden. Die verfestigten Schäume können offenporig oder geschlossenporig sein.

Es kann auch bevorzugt sein, mehrere Pufferschichten mit niedrigem Brechungsindex zu verwenden, wodurch sich eine (dis)kontinuierliche Abstufung (Graduation) ergibt.

Ein Eindringen von Flüssigkeiten (z. B. Lösemittel) oder Gasen (z. B. Luftsauerstoff oder weitere Luftbestandteile) in die Pufferschicht, z. B. beim Aufbringen der organischen Halbleiterschicht, sollte vermieden werden.

Deshalb ist es bevorzugt, wenn die Poren der Pufferschicht geschlossen sind. Geschlossene Poren sind in sich abgeschlossen und lassen kein Medium eindringen.

Ebenso kann es bevorzugt sein, eine offenporige Pufferschicht zu verwenden, deren Oberfläche, beispielsweise durch thermische Behandlung, versiegelt wird, wodurch ein Eindringen von Flüssigkeiten oder Gasen wiederum verhindert wird. Offene Poren stehen mit dem umgebenden Medium in Verbindung. Die thermische Behandlung kann beispielsweise durch Bestrahlung mit einem Laser oder durch großflächige Infrarot-Bestrahlung (z. B. gemäß WO 03/038923) stattfinden.

Die mittlere Porengröße der Schicht liegt bevorzugt in einer Größenordnung von 5 bis 500 nm, besonders bevorzugt in einer Größenordnung von 10 bis 200 nm, ganz besonders bevorzugt in einer Größenordnung von 10 bis 100 nm, wobei die Porengröße kleiner sein muss als die Schichtdicke der Pufferschicht, bevorzugt kleiner als die halbe Schichtdicke der Pufferschicht, besonders bevorzugt kleiner als die viertel Schichtdicke der Pufferschicht. Bevorzugt ist eine enge Porengrößenverteilung. Die Porengröße und die Porengrößenverteilung können beispielsweise durch Rasterelektronenmikroskopie und durch Transmissionselektronenmikroskopie bestimmt werden.

Die Porosität P der Pufferschicht liegt bevorzugt zwischen 20 und 80 %, besonders bevorzugt zwischen 30 und 60 %, ganz besonders bevorzugt zwischen 40 und 50 %, wobei unter der Porosität der Anteil des Volumens verstanden wird, der von Hohlräumen (Poren) eingenommen wird. Die für diese Anmeldung relevante Porosität lässt sich aus dem Verhältnis der Brechungsindices der porösen Schicht (nₛ) und der nicht-porösen Schicht (nₚ) bestimmen. In guter Näherung gilt für die Porosität P (in %): P = 100 · [(nₚ - nₛ)/(nₚ - 1)], wie sich durch einfache Überlegungen ergibt. Dabei lässt sich der Brechungsindex der jeweiligen dünnen Schichten wiederum durch Ellipsometrie, durch einen Prismenkoppler oder durch Oberflächenplasmonenresonanz-Spektroskopie bestimmen, wie vorne beschrieben.

Die Poren können statistisch in der Pufferschicht verteilt sein, oder sie können geordnet sein, beispielsweise in einer kubisch dichtesten oder in einer hexagonal dichtesten Packung.

Die Poren können sphärisch oder elliptisch sein. Bei elliptischen Poren können diese mit ihrer Hauptachse im Film liegen, oder sie können mit ihrer Hauptachse senkrecht zum Film stehen, oder sie können Zwischenstellungen annehmen.

Bevorzugt weist die Pufferschicht Lochleitfähigkeit auf und wird zwischen die organische Halbleiterschicht und die transparente Anode (bzw. das leitfähige dotierte Polymer, wenn vorhanden) eingebracht. Die Schichtdicke liegt bevorzugt im Bereich von 50 - 1000 nm, besonders bevorzugt im Bereich von 80 - 500 nm, ganz besonders bevorzugt im Bereich von 100 bis 400 nm, insbesondere im Bereich von 100 bis 300 nm. Eine Schichtdicke in diesem Bereich hat sich als besonders bevorzugt erwiesen, da sie einerseits ausreichend dünn ist, um die Ladungsträger noch gut zu transportieren, andererseits aber die organische Halbleiterschicht und die Elektrode optisch vollständig voneinander entkoppelt werden, wie experimentell gezeigt werden konnte. Bevorzugt liegt das Potenzial der Schicht zwischen dem Potenzial der Elektrode (bzw. des leitfähigen, dotierten Polymers) und dem des organischen Halbleiters, damit die Ladungsinjektion nicht behindert wird, d. h. dass sowohl die Ladungsinjektion der Elektrode in die Pufferschicht, wie auch aus der Pufferschicht in den organischen Halbleiter begünstigt ist. Dies kann erreicht werden durch geeignete Wahl der Materialien für die Pufferschicht sowie geeignete Substitution der Materialien.

In einer bevorzugten Ausführungsform der Erfindung wird die poröse Schicht durch Porogene erzeugt, die nach der Schichtbildung aus der Schicht entfernt werden. Unter einem Porogen im Sinne dieser Erfindung werden Verbindungen verstanden, die nach der Schichtbildung und gegebenenfalls Tempern der Schicht beispielsweise durch Spülen mit einem geeigneten Lösemittel aus der Schicht entfernt werden. Als Porogene eignen sich insbesondere Verbindungen, die chemisch denen ähneln, die die elektronisch aktive Verbindung darstellen. Dies lässt sich dadurch begründen, dass ähnliche Verbindungen nicht den Betrieb der organischen elektronischen Vorrichtung stören, wenn sie nicht vollständig aus der Schicht entfernt werden und Reste der Verbindung in der Schicht verbleiben. In einer besonders bevorzugten Ausführungsform der Erfindung wird die Schicht vernetzt. Wie die Vernetzung durchgeführt werden kann, wird hinten noch ausführlich beschrieben. Die poröse Pufferschicht lässt sich beispielsweise erzeugen, indem eine Schicht aus der vernetzbaren Verbindung für die Pufferschicht und dem Porogen aus Lösung, gegenbenenfalls unter Zusatz von Hilfsverbindungen wie beispielsweise einer Photosäure, erzeugt wird. Durch Tempern dieser Schicht findet eine Phasenseparation der vernetzbaren Verbindung und des Porogens statt. Nach dem Tempern können die vernetzbaren Domänen der Schicht, wie hinten beschrieben, vernetzt werden und das Porogen kann mit einem geeigneten Lösemittel ausgewaschen werden. Zurück bleibt eine poröse Schicht. Dies ist beispielsweise hinten in Beispiel 2 belegt.

In einer weiteren bevorzugten Ausführungsform ist die poröse Schicht aufgeschäumt. Das Aufschäumen kann auf physikalischem oder chemischem Wege geschehen. Physikalische Blähmittel sind komprimierte Gase (z. B. Stickstoff), superkritische Fluide oder niedrig siedende, gegebenenfalls substituierte Kohlenwasserstoffe, die keine unerwünschten Nebenprodukte im Schaum zurücklassen. Beim Verdunsten des Blähmittels expandiert der mit Gas übersättigte Stoff unter Blasenbildung. Durch das Verdunsten und gegebenenfalls Abkühlen erhöht sich die Viskosität, und das Schaumskelett erstarrt. Besonders bevorzugte Blähmittel sind superkritische Fluide, da hierdurch Schäume mit der gewünschten Porengröße und mit geschlossenen Poren entstehen können. Ein besonders bevorzugtes superkritisches Fluid enthält superkritisches Kohlendioxid. Um das Material der organischen Pufferschicht besser zu lösen, kann es bevorzugt sein, diesem Medium noch weitere organische Verbindungen oder Lösemittel zuzusetzen. Diese Bevorzugung ist durch die relativ leichte Handhabbarkeit, die gute Löslichkeit einer großen Reihe organischer Verbindungen darin und die Inertheit bei Betrieb der elektronischen Vorrichtung zu begründen. Chemische Blähmittel sind Feststoffe, die sich unter erhöhter Temperatur oder anderer Energieeinwirkung unter Freisetzung eines Gases zersetzen, meist organische Sauerstoff- oder Stickstoffverbindungen, z. B. Azoverbindungen, Diazoverbindungen, Azidoverbindungen, Nitrosoverbindungen oder Hydrazide (z. B. J. H. Saunders, R. H. Hansen, in K. C. Frisch, J. H. Saunders (ed.), Plastic foams, Part I, Kap. 2, Marcel Dekker, New York 1972; W. S. Fong, Foamed Plastics, Suppl. A, Process Economics Program Report 97A, SRI Int., Menlo Park, California, Jan. 1984, 29-36). Weitere geeignete Porogene sind Azoisobutyronitril, Azodicarbonsäurediethylester, Diazodinitrophenol, 2,6-Bis-(4-azidobenzyliden)-4-methylcyclohexanon, s-Trisazidotriazen (Cyanurazid), Tetrazene, Tetrabutylammoniumazid, Tetrabutylammoniumacetat und Acetonperoxid. Auch die Verwendung anorganischer Blähmittel, z. B. Carbonate, ist möglich. Weiterhin ist es möglich, während einer Vernetzungsreaktion das Blähmittel in Form eines Gases als Reaktionsprodukt der Vernetzung freizusetzen, z. B. Kohlendioxid bei der Bildung von Urethanen aus Isocyanaten und Wasser.

Insbesondere für physikalisch geschäumte Schichten kann es sinnvoll sein, Nukleationskeime zuzusetzen. Dies sind fein dispergierte Feststoffe, an denen sich aus der mit Gas bzw. superkritischem Fluid übersättigten Lösung erste Gasbläschen bilden. Durch die Konzentration der Nukleationskeime lässt sich die Porosität und die Porengröße kontrollieren.

Man kann auch mit einer Emulsion des Treibmittels in einer Flüssigkeit beginnen, die dann entweder expandiert werden kann, um die Emulsionströpfchen aufzuschäumen, oder direkt fixiert werden kann, um die Emulsionströpfchen durch anschließende Prozesse zu leeren und in Hohlräume zu verwandeln. Die Zahl und Größe der Emulsionströpfchen bestimmt dabei direkt die Eigenschaften des späteren Schaums.

Als weitere Methode zur Erzeugung von Schäumen kann das "Principle of supercritical microemulsion expansion (POSME)" zum Einsatz kommen, wobei Mikroemulsionen oder feinteilige Emulsionen aus einem überkritischen Blähmittel in Polymer entwickelt werden, wie in WO 04/058386 beschrieben.

Dabei kann es ganz besonders bevorzugt sein, wenn die oben genannten Methoden zur Erzeugung eines niedrigen Brechungsindexes miteinander kombiniert werden, da dadurch eine Schicht mit einem besonders niedrigen Brechungsindex erzeugt werden kann. So kann es besonders bevorzugt sein, wenn beispielsweise Verbindungen mit langen Alkylketten und/oder fluorierte Verbindungen in einer porösen bzw. aufgeschäumten Schicht verwendet werden.

Um die mechanische Stabilität der porösen Pufferschicht zu erhöhen, egal ob diese durch Porogene erzeugt wurde oder aufgeschäumt wurde, ist es bevorzugt, diese zu vernetzen. Die Vernetzung der Pufferschicht ist außerdem besonders bevorzugt, wenn die folgende Schicht aus Lösung aufgebracht werden soll, da die Pufferschicht durch die Vernetzung unlöslich wird und durch Lösemittel nicht mehr angegriffen werden kann. Halbleitende lumineszierende Polymere, die chemisch vernetzt werden können, werden beispielsweise in WO 96/20253 offenbart. Für die Vernetzung kommen verschiedene Methoden in Frage, beispielsweise kationische, anionische oder radikalische Polymerisation, wie sie dem Fachmann geläufig sind. Bevorzugt ist die kationische Polymerisation über folgende funktionelle Gruppen:
1) elektronenreiche Olefinderivate,
2) heteronukleare Mehrfachbindungen mit Heteroatomen oder Heterogruppierungen oder
3) Ringe mit Heteroatomen (z. B. O, S, N, P, Si), die durch kationische ringöffnende Polymerisation (cationic ring-opening polymerisation) reagieren.

Bevorzugt sind organische Materialien, bei denen mindestens ein H-Atom durch eine Gruppe ersetzt ist, die durch kationische ringöffnende Polymerisation reagiert. Einen allgemeinen Überblick über die kationische ringöffnende Polymerisation gibt beispielsweise E. J. Goethals et al., "Cationic Ring Opening Polymerization" (New Methods Polym. Synth. 1992, 67-109).

Allgemein eignen sich hierfür nicht-aromatische cyclische Systeme, in denen ein oder mehrere Ringatome gleich oder verschieden O, S, N, P, Si, etc. sind.

Als besonders geeignet haben sich Oxetan-haltige halbleitende Polymere erwiesen, wie in WO 02/10129 beschrieben. Diese können durch Zusatz einer Photosäure (Verbindung, die nach Bestrahlung mit Licht geeigneter Energie Protonen freisetzt) gezielt und kontrolliert vernetzt werden. Weiterhin kommen auch vernetzbare niedermolekulare Verbindungen in Frage, wie beispielsweise kationisch vernetzbare Triarylamine (M. S. Bayer, T. Braig, O. Nuyken, D. C. Müller, M. Groß, K. Meerholz, Macromol. Rapid Commun. 1999, 20, 224-228; D. C. Müller, T. Braig, H.-G. Nothofer, M. Arnoldi, M. Groß, U. Scherf, O. Nuyken, K. Meerholz, ChemPhysChem 2000, 207-211). Die Verwendung und Vernetzung Oxetan-haltiger Polymere in organischen elektronischen Vorrichtungen ist beispielsweise in den nicht offen gelegten Anmeldungen DE 10340711.1 und DE 102004009355.5 beschrieben.

Bevorzugt sind niedermolekulare, oligomere, dendritische oder polymere organische Halbleiter und Leiter, bei denen mindestens ein H-Atom durch eine Gruppe der Formel (1), Formel (2), Formel (3) oder Formel (4) ersetzt ist, 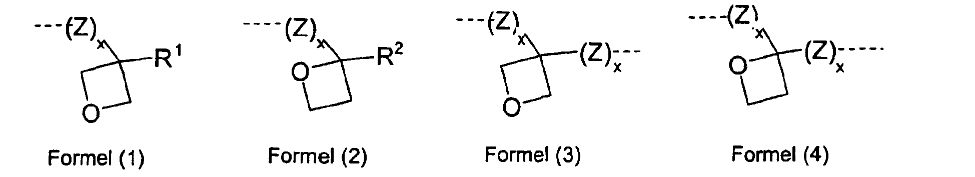 wobei für die verwendeten Symbole und Indizes gilt:
- R¹: ist bei jedem Auftreten gleich oder verschieden H, eine geradkettige, verzweigte oder cyclische Alkyl-, Alkoxy- oder Thioalkoxy- Gruppe mit 1 bis 20 C-Atomen, ein aromatisches oder heteroaromatisches Ringsystem mit 5 bis 24 aromatischen Ringatomen oder eine Alkenylgruppe mit 2 bis 10 C-Atomen, bei denen ein oder mehrere Wasserstoffatome durch Halogen oder CN ersetzt sein können und ein oder mehrere nicht benachbarte C-Atome durch -O-, -S-, -CO-, -COO-, -O-CO- ersetzt sein können;
- R²: ist bei jedem Auftreten gleich oder verschieden H, eine geradkettige, verzweigte oder cyclische Alkylgruppe mit 1 bis 20 C-Atomen, ein aromatisches oder heteroaromatisches Ringsystem mit 5 bis 24 aromatischen Ringatomen oder eine Alkenylgruppe mit 2 bis 10 C-Atomen, bei denen ein oder mehrere Wasserstoffatome durch Halogen oder CN ersetzt sein können und ein oder mehrere nicht benachbarte C-Atome durch -O-, -S-, -CO-, -COO-, -O-CO- ersetzt sein können;
- Z: ist bei jedem Auftreten gleich oder verschieden eine bivalente Gruppe -(CR³R⁴)ₙ-, bei der auch ein oder mehrere nicht benachbarte C-Atome durch -O-, -S-, -CO-, -COO- oder -O-CO- ersetzt sein können, oder ein bivalentes aromatisches oder heteroaromatisches Ringsystem mit 5 bis 40 aromatischen Ringatomen, das auch mit einem oder mehreren Resten R³ substituiert sein kann;
- R³, R⁴: sind bei jedem Auftreten gleich oder verschieden Wasserstoff, eine geradkettige, verzweigte oder cyclische Alkyl-, Alkoxy- oder Thioalkoxy-Gruppe mit 1 bis 20 C-Atomen, eine Aryl- oder Heteroaryl-Gruppe mit 5 bis 20 aromatischen Ringatomen oder eine Alkenyl-Gruppe mit 2 bis 10 C-Atomen, bei denen ein oder mehrere Wasserstoffatome auch durch Halogen oder CN ersetzt sein können; dabei können auch Reste R³ bzw. R⁴ miteinander bzw. mit R¹ oder R² ein Ringsystem bilden;
- n: ist bei jedem Auftreten gleich oder verschieden eine ganze Zahl zwischen 0 und 30, vorzugsweise zwischen 1 und 20, insbesondere zwischen 2 und 12;
- x: ist bei jedem Auftreten gleich oder verschieden eine ganze Zahl zwischen 0 und 5, bevorzugt zwischen 1 und 3;
mit der Maßgabe, dass die Anzahl der Gruppen gemäß Formel (1) bzw. Formel (2) bzw. Formel (3) bzw. Formel (4) durch die maximal verfügbaren, d. h. substituierbaren H-Atome des organischen Halbleiters oder Leiters begrenzt ist.

Durch die gestrichelte Bindung in Formeln (1) bis (4) wird die Anknüpfung an den organischen Halbleiter angedeutet. Sie ist hier nicht als Methylgruppe zu verstehen. Die Vernetzung kann durch Zusatz einer Photosäure, also einer Verbindung, die unter Bestrahlung mit Licht geeigneter Wellenlänge Protonen freisetzt, und Bestrahlung mit Licht initiiert werden, wie beispielsweise in der nicht offen gelegten Anmeldung DE 102004009355.5 beschrieben.

Die Vernetzung dieser Einheiten kann beispielsweise auch durch thermische Behandlung der Vorrichtung in diesem Stadium durchgeführt werden, insbesondere wenn die vernetzbare Pufferschicht auf eine Schicht eines dotierten leitfähigen Polymers aufgetragen wird, wie beispielsweise beschrieben in der nicht offen gelegten Anmeldung DE 10340711.1.

Bei aufgeschäumten Schichten kann die Vernetzung vor, während oder nach dem Aufschäumprozess durchgeführt werden. Bevorzugt wird die Vernetzung während dem Aufschäumprozess durchgeführt, was bedeutet, dass sich der Schäumprozess und der Vernetzungsprozess zeitlich überlappen, wobei der zeitliche Ablauf der beiden Prozesse nicht identisch sein muss. Dadurch lässt sich der gebildete Schaum besonders gut stabilisieren.

Wird die poröse Schicht durch die Verwendung von Porogenen erzeugt, so ist es besonders bevorzugt, die Vernetzung nach der Erzeugung und dem Tempern der Schicht und vor dem Entfernen des Porogens vernetzt.

Bei der erfindungsgemäßen Pufferschicht kann es sich um niedermolekulare Verbindungen handeln, die in der Schicht vernetzt und so unlöslich gemacht werden. Bevorzugt werden oligomere, dendritische oder polymere lösliche Verbindungen verwendet, die bevorzugt durch anschließende Vernetzung unlöslich gemacht werden.

Bevorzugte Materialien für die Pufferschicht leiten sich ab von lochleitenden Materialien, wie sie auch in anderen Anwendungen als Lochleiter verwendet werden. Besonders bevorzugt eignen sich hierfür vernetzbare Materialien auf Triarylamin-Basis, auf Thiophen-Basis, auf Triarylphosphin-Basis und/oder auf Pyrrol-Basis. Durch geeignete Substitution können die Potenziale dieser Verbindungen eingestellt werden. So erhält man durch Einführung elektronenziehender Substituenten (z. B. F, Cl, CN, etc.) Verbindungen mit einem niedrigeren HOMO (= höchstes besetztes Molekülorbital), während durch Einführung elektronenschiebender Substituenten (z. B. Alkoxygruppen, Aminogruppen, etc.) ein höheres HOMO erreicht wird. Da die Pufferschicht bevorzugt relativ dick ist, kann es bevorzugt sein, wenn sie freie Ladungsträger enthält und intrinsisch elektrisch leitfähig ist. Es kann sich also bevorzugt um einen organischen elektrischen Leiter handeln, der im Idealfall Ohm'sches Verhalten zeigt, bei dem also der Strom proportional zur angelegten Spannung ist, bevorzugt mit einer Leitfähigkeit > 10⁻⁸ S/cm, besonders bevorzugt mit einer Leitfähigkeit in der Größenordnung von 10⁻⁷ bis 10⁻¹ S/cm, ganz besonders bevorzugt mit einer Leitfähigkeit in der Größenordnung von 10⁻⁶ bis 10⁻² S/cm. Deshalb ist es bevorzugt, wenn die Pufferschicht dotiert ist. Die Dotierung kann beispielsweise durch Säuren (Brönsted- und/oder Lewis-Säuren) und/oder durch Oxidationsmittel erfolgen. Außer den oben genannten Materialien eignen sich hier auch geschäumte Schichten von dotiertem PEDOT (Poly(ethylendioxythiophen)) oder dotiertem PANI (Polyanilin). Aber auch undotierte Schichten können den gewünschten Effekt zeigen und können eine ausreichend hohe Ladungsträgermobilität aufweisen.

Für die Herstellung der Vorrichtungen wird in der Regel ein allgemeines Verfahren angewandt, wie beispielsweise in der nicht offen gelegten Anmeldung DE 10340711.1 beschrieben, das entsprechend ohne weiteres erfinderisches Zutun für den Einzelfall anzupassen ist. Wie geeignete Schichten mit niedrigem Brechungsindex bzw. geeignete poröse Schichten oder Schäume hergestellt werden können, ist oben bereits ausführlich beschrieben.

Überraschend bietet der erfindungsgemäße Aufbau der elektronischen Vorrichtung, in dem eine organische Pufferschicht mit niedrigem Brechungsindex verwendet wird, nun folgende Vorteile:
1) Die Auskopplung des Lichts aus der elektronischen Vorrichtung verbessert sich signifikant.
2) In Folge erhöht sich die beobachtete Effizienz der organischen elektronischen Vorrichtung, insbesondere auch die Leistungseffizienz. Dies ist für die praktische Anwendung, insbesondere für mobile Anwendungen, von höchster Bedeutung.
3) Durch die erhöhte Effizienz erhöht sich auch die Lebensdauer der organischen elektronischen Vorrichtung, da diese immer von der Helligkeit und Stromdichte abhängt, mit der die Vorrichtung betrieben wird, und durch die höhere Auskopplungseffizienz eine organische Leuchtdiode nun mit geringerer Stromdichte bei gleichbleibender beobachteter Helligkeit betrieben werden kann.
4) Der neuartige Aufbau der organischen elektronischen Vorrichtung ist problemlos zu realisieren. Insbesondere ist kein hoher technischer Aufwand nötig im Gegensatz zu Aufbauten gemäß dem Stand der Technik.
5) Der neuartige Aufbau zeigt keine Winkelabhängigkeit in dem optoelektronischen Verhalten (z. B. keine Blickwinkelabhängikeit der Emissioncharakteristik).
6) In Solarzellen und Detektoren verbessert sich die Empfindlichkeit bei Einsatz bei diffusem Licht.
7) Der neuartige Aufbau lässt sich problemlos mit den üblicherweise verwendeten Materialien und dem überlicherweise verwendeten Schichtaufbau vereinbaren. Es ist also möglich, ohne signifikante Änderungen im Aufbau die erfindungsgemäße Pufferschicht in die Vorrichtung zu integrieren.

Die vorliegende Erfindung wird durch die folgenden Beispiele näher erläutert, ohne sie darauf einschränken zu wollen. In diesen Beispielen wird nur auf organische und polymere Leuchtdioden eingegangen. Der Fachmann kann jedoch aus den aufgeführten Beispielen ohne erfinderisches Zutun weitere elektronische Vorrichtungen darstellen, wie beispielsweise organische Solarzellen, optische Verstärker, optische Detektoren, Field-Quenching-Devices und organische Laser, um nur einige weitere Anwendungen zu nennen.

### Beispiele:

### Beispiel 1: Senkung des Brechungsindex durch Zugabe einer Alkylverbindung mit niedrigerem Brechungsindex

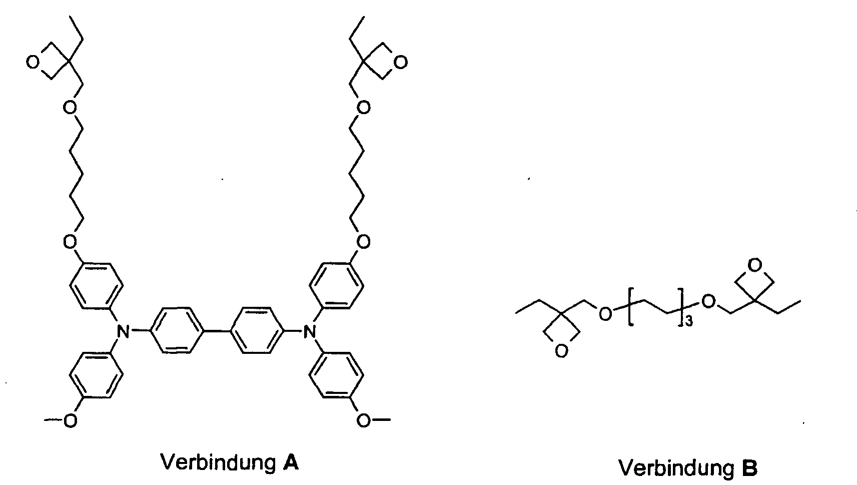

Wird mit dem Lochleiter **A** (Brechungsindex n = 1.64) eine Alkylverbindung **B** mit niedrigerem Brechungsindex (n = 1.46) copolymerisiert, so kann dadurch der Brechungsindex der lochleitenden Schicht gesenkt werden. Im vorliegenden Beispiel wird durch Zugabe von 25 Gew.% **B** eine Absenkung des Gesamtbrechungsindex auf 1.59 erreicht.

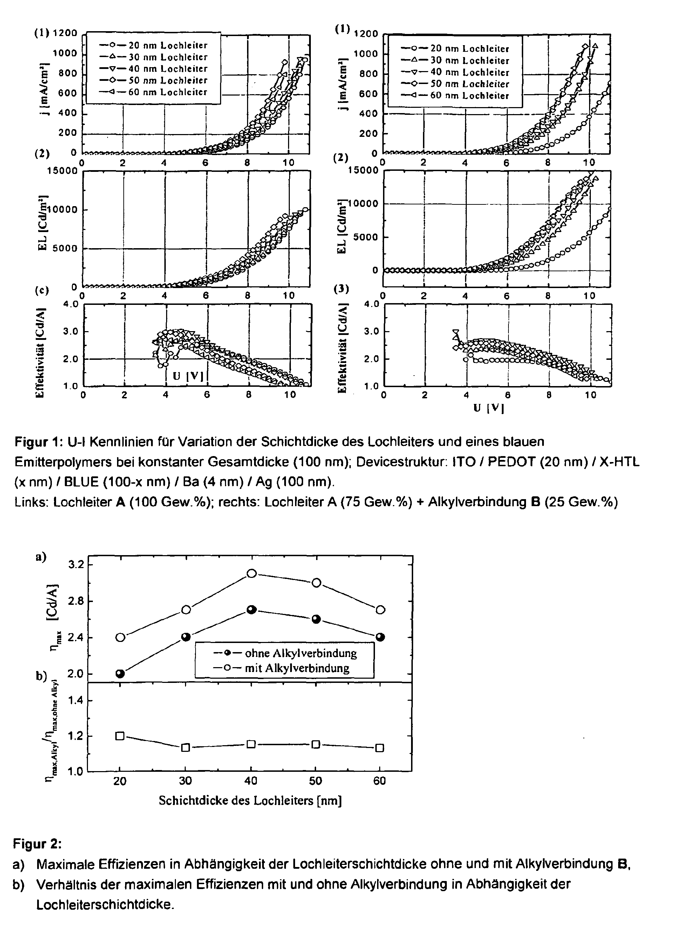

Die Variation der Lochleiterschichtdicke bei gleichzeitiger Variation der Emitterschichtdicke (Gesamtdicke konstant 100 nm) führt zu einem Maximum der Effizienz bei einer Schichtdicke von 40 nm Lochleiter unter 60 nm Emittermaterial. Im Vergleich der Daten führt der Zusatz von 25 Gew.% der Alkylverbindung **B** zu einer Effizienzverbesserung von ca. 25 %. Die U-I-Kennlinien für eine Variation der Schichtdicken sind in Figur 1 abgebildet.

In Figur 2 sind die maximalen Effizienzen der Vorrichtungen in Abhängigkeit der Schichtdicke der vernetzten Lochleiterschicht sowie das Verhältnis der Effizienzen mit bzw. ohne Zusatz von **B** dargestellt. Durch Copolymerisation von 25 Gew.% **B** wird eine durchschnittliche Verbesserung der Effizienz um 20-25 % erzielt.

### Beispiel 2: Senkung des Brechungsindex durch Erzeugung nanoporöser Strukturen

Die Erzeugung von Hohlräumen im Nanometer-Maßstab in der Lochleiterschicht zur Senkung des Brechungsindex wird durch selektives Auswaschen nach Phasenseparation erreicht. Zu dem vernetzbaren Lochleiter (Verbindung **A**) wurde ein nicht vernetzbares Lochleiter-Derivat (Verbindung **C**) gegeben.

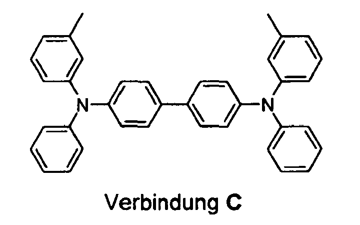

Durch Spin-coating wurde eine Schicht dieser Mischung erzeugt, durch Heizen der Schicht wurde eine Phasenseparation erreicht, durch Belichten die vernetzbare Domäne stabilisiert und in einem abschließenden Spülschritt die nicht vernetzte Komponente ausgespült.

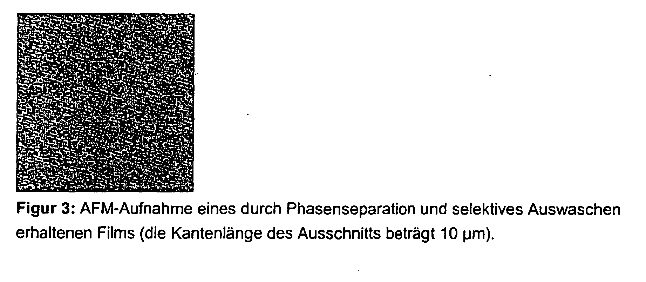

Wie mit Hilfe eines Rasterkraftmikroskops (AFM) nachgewiesen werden konnte, entstehen nano-skalige Strukturen (Durchmesser 200-300 nm; Tiefe 10-15 nm) in der Schicht (Figur 3).

## Patentansprüche

1. Organische elektronische Vorrichtungen, enthaltend Kathode und Anode, von denen mindestens eine transparent ist, und mindestens eine Schicht, enthaltend mindestens einen organischen Halbleiter, **dadurch gekennzeichnet, dass** zwischen die transparente Elektrode und die Schicht, die den organischen Halbleiter enthält, mindestens eine poröse, organische Pufferschicht eingebracht ist, welche einen Brechungsindex n < 1.6 aufweist und deren Porengröße im Nanometerbereich liegt.

2. Organische elektronische Vorrichtung gemäß Anspruch 1, **dadurch gekennzeichnet, dass** der Brechungsindex n der Pufferschicht zwischen 1.2 und 1.4 liegt.

3. Organische elektronische Vorrichtung gemäß Anspruch 1 und/oder 2, **dadurch gekennzeichnet, dass** es sich um eine organische oder polymere Leuchtdiode, eine organische Solarzelle, einen organischen optischen Detektor, eine organische Laserdiode, ein Field-Quenching-Device oder einen organischen optischen Verstärker handelt.

4. Organische elektronische Vorrichtung gemäß einem oder mehreren der Ansprüche 1 bis 3, **dadurch gekennzeichnet, dass** als Kathode Metalle, Metalllegierungen oder mehrlagige Strukturen mit verschiedenen Metallen, von denen mindestens eines eine niedrige Austrittsarbeit aufweist, verwendet werden.

5. Organische elektronische Vorrichtung gemäß einem oder mehreren der Ansprüche 1 bis 4, **dadurch gekennzeichnet, dass** die Anode ein Potenzial größer 4.5 eV vs. Vakuum aufweist.

6. Organische elektronische Vorrichtung gemäß Anspruch 5, **dadurch gekennzeichnet, dass** ein gemischtes Metalloxid als Anode verwendet wird.

7. Organische elektronische Vorrichtung gemäß einem oder mehreren der Ansprüche 1 bis 6, **dadurch gekennzeichnet, dass** der organische Halbleiter niedermolekular, oligomer, dendritisch oder polymer ist.

8. Organische elektronische Vorrichtung gemäß einem oder mehreren der Ansprüche 1 bis 7, **dadurch gekennzeichnet, dass** die Gesamtschichtdicke des bzw. der organischen Halbleiter 10 - 300 nm beträgt.

9. Organische elektronische Vorrichtung gemäß einem oder mehreren der Ansprüche 1 bis 8, **dadurch gekennzeichnet, dass** auf der Anode eine Lochinjektionsschicht verwendet wird.

10. Organische elektronische Vorrichtung gemäß einem oder mehreren der Ansprüche 1 bis 9, **dadurch gekennzeichnet, dass** die Schichtdicke der Pufferschicht im Bereich von 50 - 1000 nm liegt.

11. Organische elektronische Vorrichtung gemäß einem oder mehreren der Ansprüche 1 bis 10, **dadurch gekennzeichnet, dass** die Poren der Pufferschicht geschlossen sind.

12. Organische elektronische Vorrichtung gemäß einem oder mehreren der Ansprüche 1 bis 10, **dadurch gekennzeichnet, dass** die Pufferschicht offenporig ist und die Oberfläche thermisch versiegelt ist.

13. Organische elektronische Vorrichtung gemäß einem oder mehreren der Ansprüche 1 bis 12, **dadurch gekennzeichnet, dass** die Porengröße der Schicht in einer Größenordnung von 5 bis 500 nm liegt.

14. Organische elektronische Vorrichtung gemäß einem oder mehreren der Ansprüche 1 bis 13, **dadurch gekennzeichnet, dass** die Porosität der Pufferschicht zwischen 20 und 80 % liegt.

15. Organische elektronische Vorrichtung gemäß einem oder mehreren der Ansprüche 1 bis 14, **dadurch gekennzeichnet, dass** die organische Pufferschicht vernetzt ist.

16. Organische elektronische Vorrichtung gemäß Anspruch 15, **dadurch gekennzeichnet, dass** organische Materialien verwendet werden, bei denen mindestens ein H-Atom durch eine Gruppe ersetzt ist, die durch kationische ringöffnende Polymerisation reagiert.

17. Organische elektronische Vorrichtung gemäß Anspruch 16, **dadurch gekennzeichnet, dass** die Vernetzung über Oxetangruppen stattfindet.

18. Organische elektronische Vorrichtung gemäß Anspruch 17, **dadurch gekennzeichnet, dass** in der Pufferschicht niedermolekulare, oligomere, dendritische oder polymere organische Halbleiter oder Leiter verwendet werden, bei denen mindestens ein H-Atom durch eine Gruppe der Formel (1), Formel (2), Formel (3) oder Formel (4) ersetzt ist, 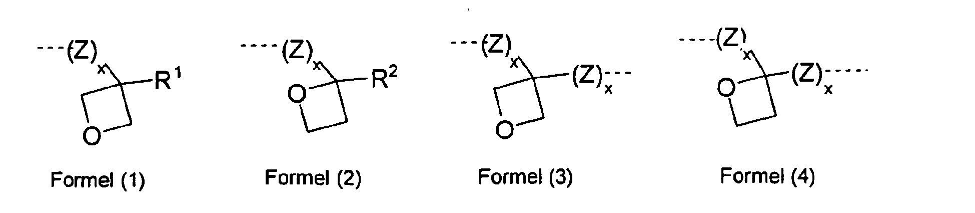 wobei für die verwendeten Symbole und Indizes gilt:
R¹ ist bei jedem Auftreten gleich oder verschieden H, eine geradkettige, verzweigte oder cyclische Alkyl-, Alkoxy- oder Thioalkoxy- Gruppe mit 1 bis 20 C-Atomen, ein aromatisches oder heteroaromatisches Ringsystem mit 5 bis 24 aromatischen Ringatomen oder eine Alkenylgruppe mit 2 bis 10 C-Atomen, bei denen ein oder mehrere Wasserstoffatome durch Halogen oder CN ersetzt sein können und ein oder mehrere nicht benachbarte C-Atome durch -O-, -S-, -CO-, -COO-, -O-CO- ersetzt sein können;
R² ist bei jedem Auftreten gleich oder verschieden H, eine geradkettige, verzweigte oder cyclische Alkylgruppe mit 1 bis 20 C-Atomen, ein aromatisches oder heteroaromatische Ringsystem mit 5 bis 24 aromatischen Ringatomen oder eine Alkenylgruppe mit 2 bis 10 C-Atomen, bei denen ein oder mehrere Wasserstoffatome durch Halogen oder CN ersetzt sein können und ein oder mehrere nicht benachbarte C-Atome durch -O-, -S-, -CO-, -COO-, -O-CO- ersetzt sein können;
Z ist bei jedem Auftreten gleich oder verschieden eine bivalente Gruppe -(CR³R⁴)ₙ-, bei der auch ein oder mehrere nicht benachbarte C-Atome durch -O-, -S-, -CO-, -COO- oder -O-CO- ersetzt sein können, oder ein bivalentes aromatisches oder heteroaromatisches Ringsystem mit 5 bis 40 aromatischen Ringatomen, das auch mit einem oder mehreren Resten R³ substituiert sein kann;
R³, R⁴ bei jedem Auftreten gleich oder verschieden Wasserstoff, eine geradkettige, verzweigte oder cyclische Alkyl-, Alkoxy- oder Thioalkoxy-Gruppe mit 1 bis 20 C-Atomen, eine Aryl- oder Heteroaryl-Gruppe mit 5 bis 20 aromatischen Ringatomen oder eine Alkenyl-Gruppe mit 2 bis 10 C-Atomen, bei denen ein oder mehrere Wasserstoffatome auch durch Halogen oder CN ersetzt sein können; dabei können auch Reste R³ bzw. R⁴ miteinander bzw. mit R¹ oder R² ein Ringsystem bilden;
n ist bei jedem Auftreten gleich oder verschieden eine ganze Zahl zwischen 0 und 30;
x ist bei jedem Auftreten gleich oder verschieden eine ganze Zahl zwischen 0 und 5;
mit der Maßgabe, dass die Anzahl der Gruppen gemäß Formel (1) bzw. Formel (2) bzw. Formel (3) bzw. Formel (4) durch die maximal verfügbaren H-Atome des organischen Halbleiters oder Leiters begrenzt ist; die gestrichelte Bindung beschreibt dabei die Anknüpfung an den organischen Halbleiter oder Leiter.

19. Organische elektronische Vorrichtung gemäß einem oder mehreren der Ansprüche 1 bis 18, **dadurch gekennzeichnet, dass** die Materialien für die Pufferschicht lochleitend sind.

20. Organische elektronische Vorrichtung gemäß Anspruch 19, **dadurch gekennzeichnet, dass** die Materialien für die Pufferschicht dotiert sind.

21. Organische elektronische Vorrichtung gemäß Anspruch 19 und 20, **dadurch gekennzeichnet, dass** die Materialien für die Pufferschicht dotierte Materialien auf Triarylamin-Basis, auf Thiophen-Basis, auf Triarylphosphin-Basis und/oder auf Pyrrol-Basis sind.

22. Verfahren zur Herstellung einer organischen elektronischen Vorrichtung gemäß einem oder mehreren der Ansprüche 1 bis 14, **dadurch gekennzeichnet, dass** die poröse Schicht durch Porogene erzeugt wird, die nach der Schichtbildung aus der Schicht entfernt werden.

23. Verfahren zur Herstellung einer organischen elektronischen Vorrichtung gemäß einem oder mehreren der Ansprüche 1 bis 14, **dadurch gekennzeichnet, dass** die Pufferschicht aufgeschäumt ist.

24. Verfahren gemäß Anspruch 23, **dadurch gekennzeichnet, dass** als Blähmittel komprimierte Gase oder niedrig siedende Kohlenwasserstoffe verwendet werden.

25. Verfahren gemäß Anspruch 23, **dadurch gekennzeichnet, dass** als Blähmittel superkritische Fluide verwendet werden.

26. Verfahren gemäß Anspruch 23, **dadurch gekennzeichnet, dass** die Pufferschicht durch chemische Blähmittel aufgeschäumt wird.

27. Verfahren gemäß einem oder mehreren der Ansprüche 23 bis 26, **dadurch gekennzeichnet, dass** nanometergroße fein dispergierte Feststoffe als Nukleationskeime zugesetzt sind.

28. Verfahren gemäß einem oder mehreren der Ansprüche 23 bis 27, **dadurch gekennzeichnet, dass** Emulsionen verwendet werden.

29. Verfahren gemäß Anspruch 28, **dadurch gekennzeichnet, dass** Mikroemulsionen oder feinteilige Emulsionen aus einem überkritischen Blähmittel in Polymer entwickelt werden.

30. Verfahren zur Herstellung einer organischen elektronischen Vorrichtung gemäß einem oder mehreren der Ansprüche 15 bis 18, **dadurch gekennzeichnet, dass** die Vernetzung während des Aufschäumprozesses durchgeführt wird.

31. Verfahren zur Herstellung einer organischen elektronischen Vorrichtung gemäß einem oder mehreren der Ansprüche 15 bis 18, **dadurch gekennzeichnet, dass** die Vernetzung nach Aufbringen und gegebenenfalls Tempern der Schicht und vor dem Entfernen der Porogene durchgeführt wird.

## Claims

1. Organic electronic devices comprising cathode and anode, at least one of which is transparent, and at least one layer comprising at least one organic semiconductor, **characterised in that** at least one porous, organic buffer layer which has a refractive index n < 1.6 and whose pore size is in the nanometre range has been introduced between the transparent electrode and the layer which comprises the organic semiconductor.

2. Organic electronic device according to Claim 1, **characterised in that** the refractive index n of the buffer layer is between 1.2 and 1.4.

3. Organic electronic device according to Claim 1 and/or 2, **characterised in that** it is an organic or polymeric light-emitting diode, an organic solar cell, an organic optical detector, an organic laser diode, a field-quenching device or an organic optical amplifier.

4. Organic electronic device according to one or more of Claims 1 to 3, **characterised in that** the cathode used comprises metals, metal alloys or multilayered structures with various metals, at least one of which has a low work function.

5. Organic electronic device according to one or more of Claims 1 to 4, **characterised in that** the anode has a potential of greater than 4.5 eV vs. vacuum.

6. Organic electronic device according to Claim 5, **characterised in that** a mixed metal oxide is used as anode.

7. Organic electronic device according to one or more of Claims 1 to 6, **characterised in that** the organic semiconductor is low-molecular-weight, oligomeric, dendritic or polymeric.

8. Organic electronic device according to one or more of Claims 1 to 7, **characterised in that** the total layer thickness of the organic semiconductor(s) is 10 - 300 nm.

9. Organic electronic device according to one or more of Claims 1 to 8, **characterised in that** a hole-injection layer is used on the anode.

10. Organic electronic device according to one or more of Claims 1 to 9, **characterised in that** the layer thickness of the buffer layer is in the range 50 - 1000 nm.

11. Organic electronic device according to one or more of Claims 1 to 10, **characterised in that** the pores of the buffer layer are closed.

12. Organic electronic device according to one or more of Claims 1 to 10, **characterised in that** the buffer layer is open-pored, and the surface has been thermally sealed.

13. Organic electronic device according to one or more of Claims 1 to 12, **characterised in that** the pore size of the layer is in an order of magnitude of 5 to 500 nm.

14. Organic electronic device according to one or more of Claims 1 to 13, **characterised in that** the porosity of the buffer layer is between 20 and 80%.

15. Organic electronic device according to one or more of Claims 1 to 14, **characterised in that** the organic buffer layer has been crosslinked.

16. Organic electronic device according to Claim 15, **characterised in that** organic materials are used in which at least one H atom has been replaced by a group which reacts by cationic ring-opening polymerisation.

17. Organic electronic device according to Claim 16, **characterised in that** the crosslinking takes place via oxetane groups.

18. Organic electronic device according to Claim 17, **characterised in that** use is made in the buffer layer of low-molecular-weight, oligomeric, dendritic or polymeric organic semiconductors or conductors in which at least one H atom has been replaced by a group of the formula (1), formula (2), formula (3) or formula (4), 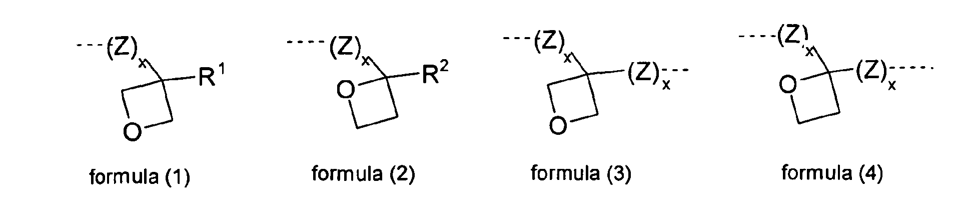 where the following applies to the symbols and indices used:
R¹ is on each occurrence, identically or differently, H, a straight-chain, branched or cyclic alkyl, alkoxy or thioalkoxy group having 1 to 20 C atoms, an aromatic or heteroaromatic ring system having 5 to 24 aromatic ring atoms or an alkenyl group having 2 to 10 C atoms, in which one or more hydrogen atoms may be replaced by halogen or CN and one or more non-adjacent C atoms may be replaced by -O-, -S-, -CO-, -COO-, -O-CO-;
R² is on each occurrence, identically or differently, H, a straight-chain, branched or cyclic alkyl group having 1 to 20 C atoms, an aromatic or heteroaromatic ring system having 5 to 24 aromatic ring atoms or an alkenyl group having 2 to 10 C atoms, in which one or more hydrogen atoms may be replaced by halogen or CN and one or more non-adjacent C atoms may be replaced by -O-, -S-, -CO-, -COO-, -O-CO-;
Z is on each occurrence, identically or differently, a divalent group -(CR³R⁴)ₙ-, in which, in addition, one or more non-adjacent C atoms may be replaced by -O-, -S-, -CO-, -COO- or -O-CO-, or a divalent aromatic or heteroaromatic ring system having 5 to 40 aromatic ring atoms, which may also be substituted by one or more radicals R³;
R³, R⁴ are on each occurrence, identically or differently, hydrogen, a straight-chain, branched or cyclic alkyl, alkoxy or thioalkoxy group having 1 to 20 C atoms, an aryl or heteroaryl group having 5 to 20 aromatic ring atoms or an alkenyl group having 2 to 10 C atoms, in which, in addition, one or more hydrogen atoms may be replaced by halogen or CN; radicals R³ or R⁴ may also form a ring system here with one another or with R¹ or R²;
n is on each occurrence, identically or differently, an integer between 0 and 30;
x is on each occurrence, identically or differently, an integer between 0 and 5;
with the proviso that the number of groups of the formula (1) or formula (2) or formula (3) or formula (4) is limited by the maximum number of available H atoms of the organic semiconductor or conductor; the dashed bond here describes the link to the organic semiconductor or conductor.

19. Organic electronic device according to one or more of Claims 1 to 18, **characterised in that** the materials for the buffer layer are hole-conducting.

20. Organic electronic device according to Claim 19, **characterised in that** the materials for the buffer layer have been doped.

21. Organic electronic device according to Claims 19 and 20, **characterised in that** the materials for the buffer layer are doped materials based on triarylamine, based on thiophene, based on triarylphosphine and/or based on pyrrole.

22. Process for the production of an organic electronic device according to one or more of Claims 1 to 14, **characterised in that** the porous layer is produced by means of porogens, which are removed from the layer after the layer formation.

23. Process for the production of an organic electronic device according to one or more of Claims 1 to 14, **characterised in that** the buffer layer has been foamed.

24. Process according to Claim 23, **characterised in that** the blowing agents used are compressed gases or low-boiling hydrocarbons.

25. Process according to Claim 23, **characterised in that** the blowing agents used are supercritical fluids.

26. Process according to Claim 23, **characterised in that** the buffer layer is foamed by means of chemical blowing agents.

27. Process according to one or more of Claims 23 to 26, **characterised in that** nanometre-size finely dispersed solids have been added as nucleation seeds.

28. Process according to one or more of Claims 23 to 27, **characterised in that** emulsions are used.

29. Process according to Claim 28, **characterised in that** microemulsions or finely divided emulsions are developed from a supercritical blowing agent in polymer.

30. Process for the production of an organic electronic device according to one or more of Claims 15 to 18, **characterised in that** the crosslinking is carried out during the foaming process.

31. Process for the production of an organic electronic device according to one or more of Claims 15 to 18, **characterised in that** the crosslinking is carried out after application and where appropriate heat treatment of the layer and before the removal of the porogens.

## Revendications

1. Dispositifs électroniques organiques comprenant une cathode et une anode dont au moins l'une est transparente et au moins une couche comprenant au moins un semiconducteur organique, **caractérisés en ce qu'**au moins une couche tampon organique poreuse qui présente un indice de réfraction n < 1,6 et dont la taille de pore est dans la plage des nanomètres a été introduite entre l'électrode transparente et la couche qui comprend le semiconducteur organique.

2. Dispositif électronique organique selon la revendication 1, **caractérisé en ce que** l'indice de réfraction n de la couche tampon est entre 1,2 et 1,4.

3. Dispositif électronique organique selon la revendication 1 et/ou 2, **caractérisé en ce qu'**il s'agit d'une diode émettrice de lumière organique ou polymérique, d'une cellule solaire organique, d'un détecteur optique organique, d'une diode laser organique, d'un dispositif à extinction de champ ou d'un amplificateur optique organique.

4. Dispositif électronique organique selon une ou plusieurs des revendications 1 à 3, **caractérisé en ce que** la cathode utilisée comprend des métaux, des alliages de métaux ou des structures multicouches avec divers métaux dont au moins l'un présente une fonction de travail faible.

5. Dispositif électronique organique selon une ou plusieurs des revendications 1 à 4, **caractérisé en ce que** l'anode présente un potentiel supérieur à 4,5 eV par rapport au vide.

6. Dispositif électronique organique selon la revendication 5, **caractérisé en ce qu'**un oxyde métallique mélangé est utilisé en tant qu'anode.

7. Dispositif électronique organique selon une ou plusieurs des revendications 1 à 6, **caractérisé en ce que** le semiconducteur organique est oligomérique, dendritique ou polymérique de poids moléculaire faible.

8. Dispositif électronique organique selon une ou plusieurs des revendications 1 à 7, **caractérisé en ce que** l'épaisseur de couche totale du/des semiconducteur(s) organique(s) est de 10 - 300 nm.

9. Dispositif électronique organique selon une ou plusieurs des revendications 1 à 8, **caractérisé en ce qu'**une couche d'injection de trous est utilisée sur l'anode.

10. Dispositif électronique organique selon une ou plusieurs des revendications 1 à 9, **caractérisé en ce que** l'épaisseur de couche de la couche tampon est dans la plage de 50 - 1000 nm.

11. Dispositif électronique organique selon une ou plusieurs des revendications 1 à 10, **caractérisé en ce que** les pores de la couche tampon sont fermés.

12. Dispositif électronique organique selon une ou plusieurs des revendications 1 à 10, **caractérisé en ce que** la couche tampon est à pores ouverts et la surface a été scellée thermiquement.

13. Dispositif électronique organique selon une ou plusieurs des revendications 1 à 12, **caractérisé en ce que** la taille de pore de la couche est d'un ordre de grandeur de 5 à 500 nm.

14. Dispositif électronique organique selon une ou plusieurs des revendications 1 à 13, **caractérisé en ce que** la porosité de la couche tampon est entre 20 et 80%.

15. Dispositif électronique organique selon une ou plusieurs des revendications 1 à 14, **caractérisé en ce que** la couche tampon organique a été réticulée.

16. Dispositif électronique organique selon la revendication 15, **caractérisé en ce que** des matériaux organiques sont utilisés, matériaux dans lesquels au moins un atome de H a été remplacé par un groupe qui réagit par polymérisation par ouverture de cycle cationique.

17. Dispositif électronique organique selon la revendication 16, **caractérisé en ce que** la réticulation est réalisée via des groupes oxétane.

18. Dispositif électronique organique selon la revendication 17, **caractérisé en ce que** sont utilisés dans la couche tampon des semiconducteurs ou conducteurs oligo-mériques, dendritiques ou polymériques de poids moléculaire faible dans lesquels au moins un atome de H a été remplacé par un groupe de la formule (1), de la formule (2), de la formule (3) ou de la formule (4), 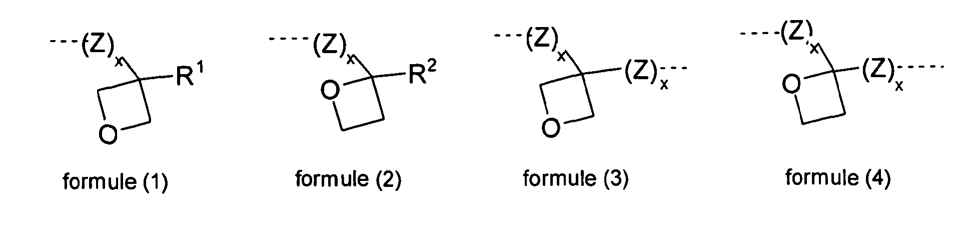 dans lesquelles ce qui suit s'applique aux symboles et indices utilisés :
R¹ est, pour chaque occurrence, de manière identique ou différente, H, un groupe alkyle, alcoxy ou thioalcoxy en chaîne droite, ramifié ou cyclique comportant de 1 à 20 atomes de C, un système de cycle aromatique ou hétéroaromatique comportant de 5 à 24 atomes de cycle aromatique ou un groupe alkényle comportant de 2 à 10 atomes de C, où un ou plusieurs atomes d'hydrogène peut/peuvent être remplacé(s) par halogène ou CN et un ou plusieurs atomes de C non adjacents peut/peuvent être remplacé(s) par -O-, -S-, -CO-, -COO-, -O-CO- ;
R² est, pour chaque occurrence, de manière identique ou différente, H, un groupe alkyle en chaîne droite, ramifié ou cyclique comportant de 1 à 20 atomes de C, un système de cycle aromatique ou hétéroaromatique comportant de 5 à 24 atomes de cycle aromatique ou un groupe alkényle comportant de 2 à 10 atomes de C, où un ou plusieurs atomes d'hydrogène peut/peuvent être remplacé(s) par halogène ou CN et un ou plusieurs atomes de C non adjacents peut/peuvent être remplacé(s) par -O-, -S-, -CO-, -COO-, -O-CO- ;
Z est, pour chaque occurrence, de manière identique ou différente, un groupe divalent -(CR³R⁴)ₙ-, où, en outre, un ou plusieurs atomes de C non adjacents peut/peuvent être remplacé(s) par -O-, -S-, -CO-, -COO- ou -O-CO-, ou un système de cycle aromatique ou hétéroaromatique divalent comportant de 5 à 40 atomes de cycle aromatique, lesquels peuvent également être substitués par un ou plusieurs radicaux R³ ;
R³, R⁴ sont, pour chaque occurrence, de manière identique ou différente, hydrogène, un groupe alkyle, alcoxy ou thioalcoxy en chaîne droite, ramifié ou cyclique comportant de 1 à 20 atomes de C, un groupe aryle ou hétéroaryle comportant de 5 à 20 atomes de cycle aromatique ou un groupe alkényle comportant de 2 à 10 atomes de C, où, en outre, un ou plusieurs atomes d'hydrogène peut/peuvent être remplacé(s) par halogène ou CN ; des radicaux R³ ou R⁴ peuvent également former un système de cycle ici les uns avec les autres ou avec R¹ ou R²;
n est, pour chaque occurrence, de manière identique ou différente, un entier entre 0 et 30 ;
x est, pour chaque occurrence, de manière identique ou différente, un entier entre 0 et 5 ;
sous réserve que le nombre de groupes de la formule (1) ou de la formule (2) ou de la formule (3) ou de la formule (4) est limité par le nombre maximum d'atomes de H disponibles du semiconducteur ou conducteur organique ; la liaison en pointillés décrit le lien sur le semiconducteur ou conducteur organique.

19. Dispositif électronique organique selon une ou plusieurs des revendications 1 à 18, **caractérisé en ce que** les matériaux pour la couche tampon sont à conduction de trous.

20. Dispositif électronique organique selon la revendication 19, **caractérisé en ce que** les matériaux pour la couche tampon ont été dopés.

21. Dispositif électronique organique selon les revendications 19 et 20, **caractérisé en ce que** les matériaux pour la couche tampon sont des matériaux dopés basés sur triarylamine, basés sur thiophène, basés sur triarylphosphine et/ou basés sur pyrrole.

22. Procédé pour la fabrication d'un dispositif électronique organique selon une ou plusieurs des revendications 1 à 14, **caractérisé en ce que** la couche poreuse est produite au moyen de porogènes, lesquels sont enlevés de la couche après la formation de couche.

23. Procédé pour la fabrication d'un dispositif électronique organique selon une ou plusieurs des revendications 1 à 14, **caractérisé en ce que** la couche tampon a été mise sous forme de mousse.

24. Procédé selon la revendication 23, **caractérisé en ce que** les agents de soufflage utilisés sont des gaz comprimés ou des hydrocarbones à point d'ébullition faible.

25. Procédé selon la revendication 23, **caractérisé en ce que** les agents de soufflage utilisés sont des fluides supercritiques.

26. Procédé selon la revendication 23, **caractérisé en ce que** la couche tampon est mise sous forme de mousse au moyen d'agents de soufflage chimiques.

27. Procédé selon une ou plusieurs des revendications 23 à 26, **caractérisé en ce que** des solides dispersés finement de la taille des nanomètres ont été ajoutés en tant que germes de nucléation.

28. Procédé selon une ou plusieurs des revendications 23 à 27, **caractérisé en ce que** des émulsions sont utilisées.

29. Procédé selon la revendication 28, **caractérisé en ce que** des microémulsions ou des émulsions finement divisées sont développées à partir d'un agent de soufflage supercritique dans un polymère.

30. Procédé pour la fabrication d'un dispositif électronique organique selon une ou plusieurs des revendications 15 à 18, **caractérisé en ce que** la réticulation est mise en oeuvre pendant le processus de moussage.

31. Procédé pour la fabrication d'un dispositif électronique organique selon une ou plusieurs des revendications 15 à 18, **caractérisé en ce que** la réticulation est mise en oeuvre après l'application et lorsque approprié, un traitement thermique de la couche et avant l'enlèvement des porogènes.
